# EUROPEAN PATENT APPLICATION

(11) **EP 1 403 754 A2**
(43) Date of publication of application: **31.03.2004**
(21) Application number: 03103264.2
(22) Date of filing: 01.09.2003
(51) Int. Cl.: G06F 1/32, B60R 16/02

(54) **Computer in a vehicle**

(30) Priority: 03.09.2002 SE 0202599
(71) Applicant: Scania CV Aktiebolag (publ), 151 87 Södertälje (SE)
(72) Inventor: Björkman, Mathias, SE-146 50, Tullinge (SE)

(57) **Abstract**

The invention relates to a vehicle computer (1), comprising a motherboard (2), a first printed circuit board (3) connected to the motherboard for controlling power supply to at least the motherboard. The vehicle computer also comprises a second printed circuit board (4) for wireless telecommunications, the second printed circuit board being connected to the first printed circuit board, and the first printed circuit board comprises power control means (25, 37) adapted to cause the vehicle computer to enter a first power mode (46) in which the power supply to the motherboard is off and the power supply to the second printed circuit board is on. The invention also relates to the first printed circuit board, a vehicle comprising the vehicle computer, a computer program for controlling the power modes and a computer program product comprising the computer program.

## Description

### Technical Field of the Invention

The present invention relates to a vehicle computer according to the preamble of claim 1. The invention also relates to a vehicle comprising the vehicle computer, a printed circuit board in the vehicle computer, a computer program, which is used by the printed circuit board, and a computer program product comprising the computer program.

### Background of the invention

Internal and external data communication for vehicles generally becomes more and more complex and the number of functions and systems connected or integrated in the internal vehicle computer network is growing. A problem with an increasing number of power demanding units is that they require an increased supply of electricity from a system which has stringent current limitations. Installing auxiliary batteries in the vehicle is one solution to the problem but the batteries are heavy and take up significant space often needed for other units. Especially in modem information systems for e.g. trucks, several functions are requested also when the engine of the truck is switched off, such as television, e-mail programs, Internet surfing and phone services. The batteries are then rapidly discharged.

A PC (Personal Computer) can be used in the vehicle for connecting external devices through wireless communications systems/technologies such as GSM (Global System for Mobile communications), GPRS (General Packet Radio Service) and Orbcomm with the vehicle internal ECUs (Electronic control units). The PC may also be used to store vehicle information sent to and from the ECUs. There are several advantages of using a PC system, such as the availability of computer programs. A disadvantage with a PC-based system in a vehicle is the long boot-up time, especially at low temperatures when the PC needs to be heated before it can be started. Through the long boot-up time, the PC fails to register important vehicle information from the ECUs and communication between the vehicle and external devices, such as satellites, cannot be performed before the PC has been booted and relevant software applications are running.

EP-1069494-A2 discloses a PC-based vehicle information, communication and entertainment system, which is intended to provide efficient and robust power management of an in-vehicle PC-based system, allowing a CISC (Complex Instruction Set Computer) processor to operate in a mobile environment with low power consumption and fast boot-up time. The system comprises a motherboard, i.e. a main printed circuit board, which contains sockets that accept additional boards. The motherboard comprises a main CISC processor and a power management chip set supplying power to the CISC processor. The chip set receives several different regulated voltages from an auxiliary board comprising a reduced power microprocessor, which executes program instructions contained in a ROM (Read-only memory) on the auxiliary board. The reduced power microprocessor controls a power controller and regulator which has a plurality of switched and unswitched regulated voltage outputs. Each of theses regulated voltages is provided to the motherboard and then distributed to various components that use them, including the chip set. The power controller also provides regulated voltages to a GPS (Global Positioning System) receiver and the motherboard is connected to a video card. There are also six different power modes disclosed, but none of them enables wireless telecommunications when the ignition is off.

### Summary of the invention

It is therefore an object of the invention to provide an electricity-saving vehicle computer for handling e.g. phone calls, wirelessly transmitted messages, entertainment and display of information in a vehicle.

It is also an object of the invention to provide a vehicle computer in a vehicle that enables a computer to transmit or receive data to and from vehicle external devices, such as land based antennas or satellites connected to e.g. a vehicle monitoring centre, although the ignition for the vehicle is off and/or the vehicle computer is in a power-saving mode.

The invention relates to a vehicle computer. The vehicle_computer comprises a motherboard, a first printed circuit board connected to the motherboard for controlling power supply to at least the motherboard and a second printed circuit board adapted for wireless telecommunications. The second printed circuit board is connected to the first printed circuit board and the first printed circuit board comprises power control means adapted to cause the vehicle computer to enter a first power mode in which the power supply to the motherboard is off and the power supply to the second printed circuit board is on. Hereby is achieved that the vehicle computer is able to receive wirelessly transmitted information, such as phone calls, messages or the like, from vehicle external devices, even though the motherboard is shutdown.

In one embodiment, the vehicle computer is adapted for connection with a display means and the power control means are also adapted to cause the vehicle computer to enter a second power mode in which the power supply to the display means is off whereas the power supply to the motherboard and the second printed circuit board is on. Hereby an energy-saving second power mode is implemented and a driver of the vehicle is not distracted by the light from the display means. A driver is particularly distracted by the light from the display means during night driving and this distraction is thus avoided.

In another embodiment of the vehicle computer, the power control means are also adapted to cause the vehicle computer to enter a third power mode in which the second printed circuit board is fully powered and the motherboard is starting an operating system for the vehicle computer. Hereby is achieved that wirelessly transmitted information from external devices may be received by the vehicle computer during the boot-up time for the operating system processed by the motherboard.

In yet another embodiment of the vehicle computer, the power control means also are adapted to control the power supply to a GPS signal receiver connected to the first printed circuit board in such a way that the power supply to the GPS signal receiver is off in the first power mode and is on in the second power mode. Hereby is achieved that a GPS signal receiver connected to the first circuit board is not consuming any power although the first printed circuit board is supplied with power.

In still another embodiment of the vehicle computer, the power control means also enable the vehicle computer to enter a fourth power mode in which the second printed circuit board, the display means and the motherboard are fully powered or a fifth power mode in which the power supply to the second printed circuit board, the display means and the motherboard is off. Hereby is achieved that the vehicle computer has a power mode in which the vehicle computer is fully powered and another power mode in which a full shutdown of the vehicle computer is possible.

The vehicle computer may also comprise a video processor board connected to the motherboard and to a rear-view camera. Hereby is achieved that the display means may be used for showing images from the rear-view camera processed by the video processing board and that the energy supply of the video processing board is controlled through the motherboard.

The second printed circuit board may be adapted for enabling GSM phone calls and SMS (Short Message Service) messages between the vehicle computer and a vehicle external device. Hereby is achieved that a commonly used digital cellular phone technology may be used for communications between the vehicle computer/driver and the external device.

The invention also relates to a vehicle comprising the vehicle computer.

Furthermore the invention relates to a printed circuit board for a vehicle computer. The printed circuit board comprises connector means adapted for communication with a motherboard of the vehicle computer, power control means for controlling supply of power to at least the motherboard and a second printed circuit board for wireless telecommunications with a vehicle external device and a first connector adapted for communication with the second printed circuit board. The power control means are adapted to cause the vehicle computer to enter a first power mode where the power supply to the motherboard is off and the power supply to the second printed circuit board is on.

In one embodiment of the printed circuit board, the connector means adapted for communication with the motherboard comprises a second connector for receiving and transmitting signals related to power mode control and a third connector adapted for receiving and transmitting information related to wireless telecommunications, such as AT commands, with the vehicle external devices. Hereby is achieved that information related to wireless telecommunications may be sent from the motherboard to the second printed board via the first connector and the third connector on the printed board without affecting any applications running on the motherboard and using the second printed circuit board as a gateway for wireless telecommunications.

The printed circuit board may also comprise a CAN (Controller Area Network) interface for communication with at least one ECU, such as an engine control unit or an anti-theft alarm control unit, integrated in the vehicle. Hereby is achieved that the printed circuit board is able to communicate with ECUs and forward messages from the ECUs to the second printed board for wireless transmission to a vehicle external device.

The printed circuit board may in one embodiment comprise a vehicle data logging means for saving vehicle data received from the CAN interface when vehicle data is received after an ignition signal has been received. Hereby is achieved that the printed circuit board is able to save vehicle data transmitted through the CAN interface before the operating system is functioning. Hence important vehicle data is not lost during the relatively long boot-up time, especially when the vehicle computer is cold, for a modem operating system for a PC-based computer.

Moreover, the invention relates to a computer program for causing a first printed circuit board in a vehicle computer to control different power modes for the vehicle computer, where the vehicle computer also comprises a motherboard connected to the first printed circuit board and a second printed circuit board for wireless telecommunication connected to the first printed circuit board. The computer program comprises computer usable code means which when run on the first printed circuit board causes the vehicle computer to enter a first power mode in which power supply to the motherboard is off and the power supply to the second printed circuit board is on.

The computer program may comprise computer usable code mean which when run on the first printed circuit board causes the vehicle computer to enter a second power mode in which the power supply to the motherboard and the second printed circuit board is on whereas power supply to a display means connected to the motherboard is off.

The computer program may also comprise computer usable code means which when run on the first printed circuit board causes the vehicle computer to enter a third power mode in which the second printed circuit board is fully powered and the motherboard is starting an operating system for the vehicle computer.

The computer program may furthermore comprise computer usable code means which when run on the first printed circuit board causes the power supply to a GPS signal receiver connected to the first printed circuit board to be off in the first power mode and to be on in the second power mode.

In addition the invention relates to a computer program product, such as a floppy disc, CD, DVD, flash memory, ROM, PROM (Programmable Read Only Memory), EPROM (Erasable Programmable Read Only Memory), hard disk etc, comprising a computer readable medium and the computer program recorded on the computer readable medium. Hereby is achieved that the computer program easily can be distributed and/or loaded into and processed by a computer.

### Brief Description of the Drawings

The objects, advantages and effects as well as features of the present invention will be more readily understood from the following detailed description of some embodiments of the invention, when read together with the accompanying drawings, in which:
Fig. 1 is a schematic block diagram showing a computer system employing a vehicle computer according to the invention;
Fig. 2 is a schematic block diagram of a motherboard used in the computer system;
Fig. 3 is a schematic block diagram of a first printed circuit board connected to the motherboard;
Fig. 4 is a schematic block diagram of a second printed circuit board adapted for wireless telecommunications;
   and
Fig. 5 is a state diagram showing transitions between different power modes for the vehicle computer.

### Detailed Description of Embodiments

While the invention covers various modifications and alternative constructions, suitable embodiments of the invention are described in conjunction with the drawings and will hereinafter be described in detail. However it is to be understood that the specific description and drawings are not intended to limit the invention to the specific forms disclosed. On the contrary, it is intended that the scope of the claimed invention includes all modifications and alternative constructions thereof falling within the spirit and scope of the invention as expressed in the appended claims to the full range of their equivalents.

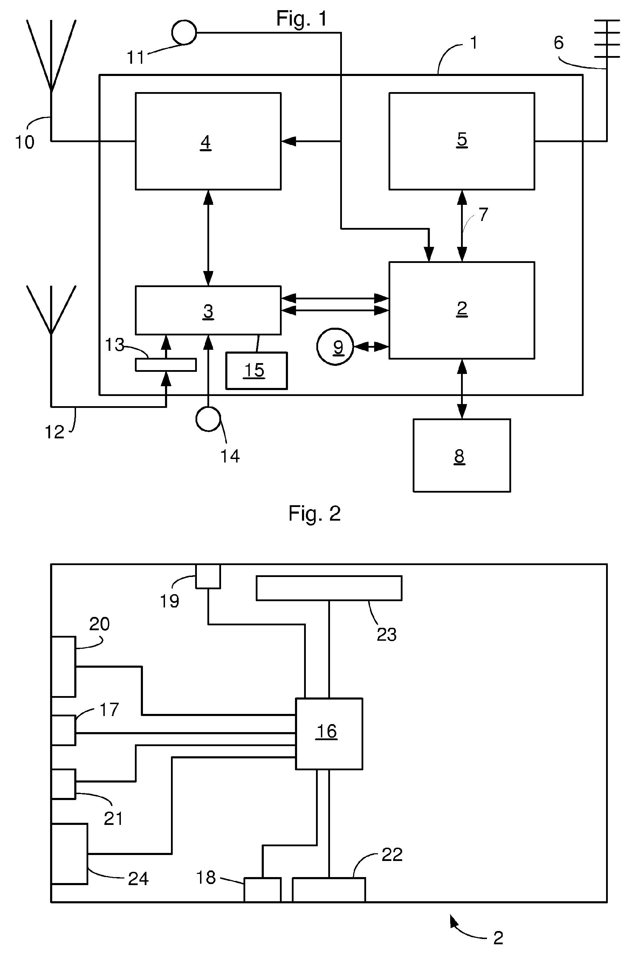

Fig. 1 shows a schematic block diagram of a computer system which is adapted to be installed in a vehicle (not shown), such as a bus or a truck, in order to enable e.g. a multimedia and communication system in the vehicle. The computer system comprises a PC-based vehicle computer 1, which comprises a motherboard 2, a first printed circuit board 3 for inter alia power control for the computer system, a second printed circuit board 4 for wireless telecommunications according to e.g. GSM with or without GPRS, Orbcomm and/or UMTS (Universal Mobile Telecommunications system) and a video processor board 5 for decoding and processing received video and audio signals. The video processor board 5 is connected to at least one television/radio antenna 6, such as a TV/FM antenna, and adapted for receiving television and radio signals from radio or television broadcasting transmitters. One or more cameras (not shown), such as a rear-view camera, an infra-red camera and/or a lane departure warning camera, may also be connected to the video processor board 5. The video processor board 5 comprises all the necessary standard components known in the art for receiving and decoding the received signals according to one or several desired standards and it is able to communicate with the motherboard 2 through at least one first bus 7, e.g. a PCI (Peripheral Component Interconnect) bus, an ISA (Industry Standard Architecture) bus, an AGP (Accelerated Graphics Port) bus, a USB (Universal Serial Bus) or an IEEE 1394 bus (Firewire). A display means 8, such as a touch screen, is in this embodiment connected to the motherboard 2 and is used as a computer monitor, a TV screen and as a monitor for e.g. the rear-view camera. A hard disk 9 comprising at least an operating system for the vehicle computer 1 is also connected to the motherboard 2. A second antenna 10 for sending and receiving wireless telecommunications signals according to any one of the telecommunications standards/techniques mentioned above to and from the vehicle computer 1 is connected to the second printed circuit board 4. A microphone 11 is directly connected to the second printed circuit board 4 and the motherboard 2 for enabling functions such as speak recognition, voice mail and phone calls. A third antenna 12 for receiving GPS signals from e.g. satellites is in this embodiment connected to the first printed circuit board 3 via a GPS signal receiver 13 installed in the vehicle computer 1. The GPS signal receiver 13 may alternatively be a separate computer external unit connected to the vehicle computer 1. A push button 14 and a backup battery 15 are also connected to the first printed circuit board 3. Although not shown, other devices may of course also be connected to the printed circuit boards 3 and 4, the video processor board 5 and the motherboard 2 in the vehicle computer 1. Examples are a CD player, a DVD player and external flash memories and hard disks, which may be connected to the motherboard. Other examples are mentioned below.

As is schematically illustrated in Fig. 2, the motherboard 2 comprises a first microprocessor unit 16 connected to a socket 17, such as an IDE (Integrated Drive Electronics) socket, for communication with the hard disk 9. The first microprocessor unit 16 is also connected to the following sockets/ports/interfaces/connectors fixed on the motherboard 2 for enabling connection of devices to the motherboard 2: at least one USB port 18 for a keyboard and/or a pointing device (not shown); a fourth connector 19 (the first, second and third connector will be described below) for the microphone 11; a fifth connector 20, such as PCI interface or a CAN interface, for interalia power mode communication with the first printed circuit board 3; a sixth connector 21 for information related to wireless telecommunications, such as AT commands in the case where GSM is supported by the second printed circuit board 4; a seventh connector 22 for communicating with the display means 8, an eighth connector 23 for connecting the motherboard 2 with the video processor board 5 via the first bus 7 and a first power connector 24 for receiving power controlled by the first printed circuit board 3. Furthermore the motherboard 2 may comprise several other additional sockets/ports/connectors known in the art but not specifically related to the invention, such as audio and video connectors commonly attached to motherboards.

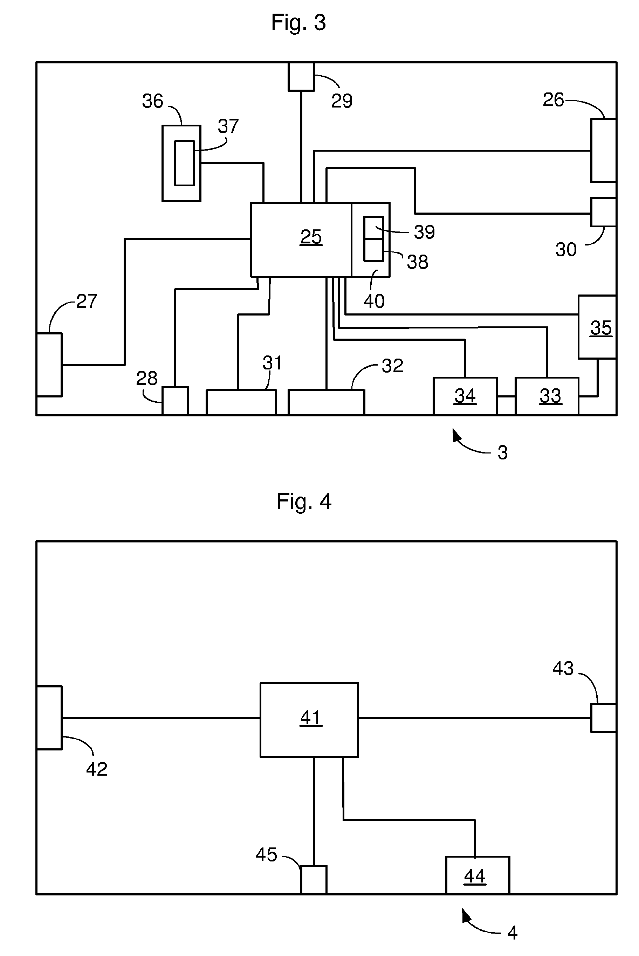

Fig. 3 schematically illustrates the first printed circuit board 3, which comprises a second microprocessor unit 25 connected to: a second connector 26 for communication with the motherboard 2 via the fifth connector 20; a CAN interface 27 or any other suitable interface, such as TTCAN and FlexRay, for communication with e.g. one or several vehicle internal ECUs (not shown) for e.g. the transmission of diagnosis parameters, alarms and an ignition signal to identify whether the vehicle is in an electrically powered state or an unpowered state; a ninth connector 28 for communication with the GPS signal receiver 13; a first connector 29 for communication of information related to wireless telecommunications with the second printed circuit board 4; a third connector 30 for communication of information related to wireless communications with the motherboard 2 via the sixth connector 21; a plurality of input ports 31 for e.g. the push button 14; and at least one temperature sensor (not shown) inside the vehicle computer 1. An ignition switch may alternatively be directly connected to the first printed circuit board for receiving the ignition signal instead of the ignition signal being received from the CAN interface 27. Based upon for instance signals received from the ignition switch and the push button 14, the second microprocessor unit 25 determines an appropriate power mode for the motherboard 2, the display means 8, the video processor board 5, the GPS signal receiver 13, the first printed circuit board 3 and the second printed circuit board 4. There are also output ports 32 on the first printed circuit board 3 connected to the second microprocessor unit 25, e.g. for sending signals to loudspeakers, an external amplifier, a cooling means for the vehicle computer 1, such as a fan, and heating means inside the vehicle computer 1 for heating the vehicle computer 1. For controlling the power supply to the motherboard 2, the video processor board 4, the GPS signal receiver 13 and the first and the second printed circuit board, the first printed circuit board 3 comprises a second power connector 33 for connecting the vehicle computer 1 to a power source (not shown), such as the ordinary vehicle battery/batteries/electricity supply system for the electrical system of the vehicle; a third power connector 34 connected to the backup battery 15 for the supply of power in case of a power supply interruption or insufficient power supply from the ordinary vehicle electricity supply system; and a fourth power connector 35 for supplying power to the motherboard 2, the video processor board 5, the display means 8, the GPS signal receiver 13 and the second printed circuit board 4.

At least one first non-volatile memory 36, such as a flash memory, an EPROM or a ROM is mounted on the first printed circuit board 3 and connected to or integrated in the second microprocessor unit 25. According to the shown embodiment, the memory 36 comprises a power mode computer program 37 for causing the second microprocessor unit 25 to control the power modes of the vehicle computer 1. In this embodiment the power mode computer program 37 and the second microprocessor unit 25 are thus power control means for controlling the different power modes of the vehicle computer 1. The second microprocessor unit 25 also comprises a CAN interface computer program 38 which is used to access a CAN bus for the ECUs via the CAN interface 27. The CAN interface computer program 38 comprises a vehicle data logging means 39 in the form of a vehicle data logging program module which causes the second microprocessor unit 25 to start logging CAN data as soon as the ignition has been turned on. The CAN data is preferably stored in the first non-volatile memory 36 but could also be stored in a second non-volatile memory 40 used for storing the CAN interface computer program 38 and comprised in the second microprocessor unit 25. Hereby vehicle data is logged even if the motherboard 2 has not completed the boot-up routine. It must also be noted that the power mode computer program 37 may alternatively be installed in the second non-volatile memory 40 and that the CAN interface computer program and the power mode computer program may be modules of a larger computer program for controlling the functions of the first printed circuit board 3.

Fig. 4 schematically illustrates the second printed circuit board 4, which is adapted to support wireless communications of e.g. voice, data, e-mail and messages like SMS messages, EMS (Enhanced Message Service) messages and/or MMS (Multimedia Message Service) messages. The second printed circuit board 4 comprises a third microprocessor unit 41, which for instance is connected to the following connections attached to the second printed circuit board 4: a tenth connector 42 for the second antenna 10, an eleventh connector 43 for the microphone 11, a fifth power connector 44 for receiving electricity from the first printed circuit board 3 and a twelfth connector 45 for two-way communications of wireless telecommunications information, such as AT commands used for GSM phone calls, with the first printed circuit board 3 through the first connector 29. All other components, such as a SIM (Subscriber Identity Module) card holder, suitable for wireless communications according to the telecommunications standards/technologies mentioned above, are suitably mounted on the second printed circuit board 4, but they are not described more in detail since they are known to a person skilled in the art and not as such included in the invention. Some of those components, such as the SIM card holder may of course alternatively be comprised on the first printed circuit board 3.

The first, third, fifth, ninth, and twelfth connector may for example be DB connectors and communication through them may use e.g. the TIA/EIA-232-E standard.

It must be emphasised that wireless communications information, such as the before mentioned AT commands, in this embodiment is transmitted between the second printed circuit board 4 and the motherboard 2 through the first printed circuit board 3, i.e. through the eleventh, first, third and fifth connector. However applications processed by the motherboard 2 and communicating with external devices through the second printed circuit board 4 will not register the presence of the first printed circuit board 3, although the second microprocessor unit 25 also is involved in the forwarding of information related to the wireless communications.

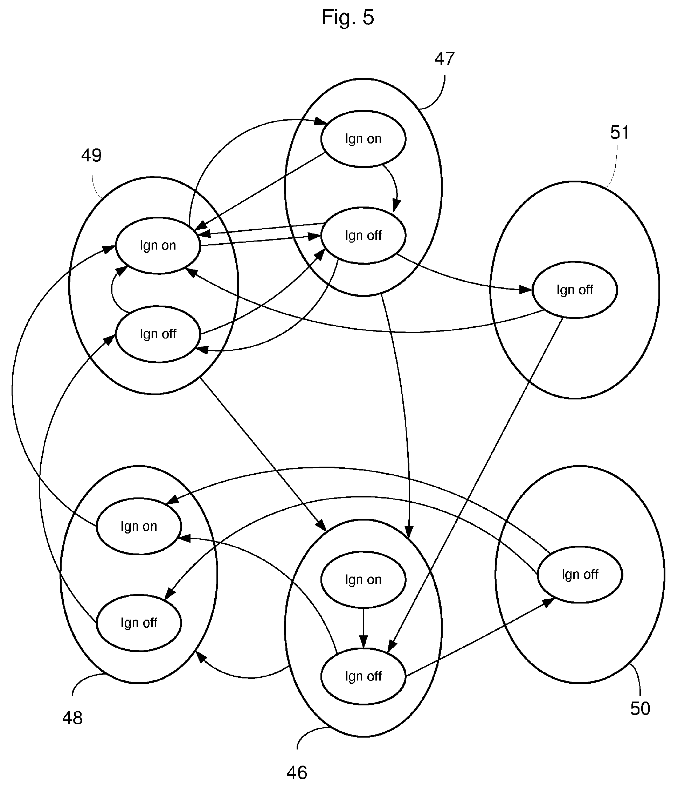

Having described some embodiments of the computer system according to the invention, different power modes for the vehicle computer 1 will now be described in conjunction with Fig. 5. The power mode computer program 37 causes the vehicle computer 1 to be capable of alternating between at least a first power mode 46, here called 'Standby'; a second power mode 47, here called 'Black panel'; a third power mode 48, here called 'Pre-on'; a fourth power mode 49, here called 'On'; a fifth power mode 50, here called 'Off' and a sixth power mode 51, here called 'Shutdown'. In the power mode On, the vehicle computer 1/computer system can be said to be fully powered, i.e. at least the motherboard 2, the first printed circuit board 3, the video processor board 5, the second printed circuit board 4, the display means 8, the hard disk 9 and the GPS signal receiver 13 is fully powered in order to gain 'normal' operation without having any reduced functionality due to insufficient power. In the power mode Off, the computer system is not powered at all, i.e. the motherboard 2, the first and second printed circuit board 3 and 4 respectively, the video processor board 5, the display means 8 and the GPS signal receiver 13 are off. In order to minimise driver distraction caused by the display means 8, the display means 8 is off in the Black panel mode, whereas the motherboard 2, the first and second printed circuit board, the video processor board 5 and the GPS signal receiver 13 is fully powered. The black panel mode is a pre-mode for the Standby mode and the time for entering the On mode from the black panel mode is relatively short. The Pre-on mode is a temporary mode where it is possible to receive phone calls although the motherboard 2 is still not fully powered. In this mode the motherboard 2 is charged to reach its fully powered state. The first and second printed circuit board, 3 and 4, and the GPS signal receiver 13 are fully powered in the Pre-on mode, but since the motherboard 2 is not fully powered, the video processor board is off. During the Standby mode, the vehicle computer requires relatively little power compared to the On, Black Panel and Pre-on modes, although the vehicle computer 1 is able to handle wireless phone calls and messages from vehicle external transmitters/systems, wirelessly send messages and to handle certain data, e.g. different alarms, such as a burglar alarm received through e.g. the CAN interface 27 or another digital interface (not shown). The motherboard 2, the video processor board 5, the display means 8 and the GPS signal receiver 13 are here off, whereas the second printed circuit board 4 is fully powered and thereby ready to receive wirelessly transmitted data. The first printed circuit board 3 may during the Standby mode alternate between two different internal power modes, one where the first printed circuit board 3 is fully powered and one where it is in a down-clocked sleep mode in order to save power. During the Standby mode the first printed circuit board 3 remains in the sleep mode as long as no phone call or message is received by the second printed circuit board 4. The first printed circuit board 3 changes to the fully powered mode as soon as a phone call, message or alarm is received. The shutdown mode is a temporary state where program applications and the operating system are shutting down. In the shutdown mode the motherboard 2, the first and second printed circuit board, the video processor board 5 and the GPS signal receiver 13 are on whereas the display means 8 is off.

The transition between the six power modes will now be described, starting from the Off mode where the ignition for the vehicle always is off. If the ignition is turned on, an ignition signal is received by the first printed circuit board 3 and the vehicle computer 1 changes into the Pre-on mode. The vehicle data logging program module causes the second microprocessor 25 to register incoming CAN data from the ECUs during the Pre-on mode. If an operator pushes the push button 14 for a shorter time than a first predetermined time, the vehicle computer 1 also changes into the Pre-on mode, although the ignition is not on.

As soon as the motherboard 2 has been powered up to a fully powered state and a temperature higher than a predetermined temperature is sensed by the at least one temperature sensor in the vehicle computer 1, the vehicle computer 1 changes into the On mode and the motherboard 2 starts to boot the operating system and any other auto-started computer programs processed by the motherboard 2. If the ignition is turned on in the On mode, nothing happens except that the second microprocessor 25 starts to log CAN data from the ECUs with the help of the vehicle data logging means 39. If the ignition is on in the On mode and the push button 14 is pushed for a shorter time than the first predetermined time, the vehicle computer 1 changes into the Black panel mode. If the ignition is off and the push button 14 is pushed for a shorter time than the first predetermined time or if the vehicle computer 1 continuously has been in the On mode for more than a second predetermined time, the vehicle computer also changes into the Black panel mode. If the ignition is turned off during the On mode, the vehicle computer 1 also enters the Black panel mode.

If the vehicle computer 1 is in the black panel mode and either the push button 14 is pushed for a shorter time than the first predetermined time or the second printed circuit board 4 receives wirelessly transmitted data, such as a phone call, the vehicle computer 1 changes to the On mode whether or not the ignition is on. If the ignition is turned off during the Black panel mode nothing happens. If the ignition is off and the ignition is turned on during the Black panel mode, the vehicle computer 1 changes to the On mode. If the push button 14 is pushed for a longer time than the first predetermined time during the black panel mode or the On mode or if the first printed circuit board 3 during these two modes receives a signal from the motherboard 2 that the motherboard is ready for shutdown, the vehicle computer changes to the Standby mode after the first printed circuit board has stopped the supply of power to the motherboard 2 in response to the signal.
The signal from the motherboard 2 may have been initiated by an operator instructing the initiation of a shutdown computer program for the motherboard 2. If the first printed circuit board 3 during the Black panel mode monitors that no power has been supplied from the power source for more than a third predetermined time and there is no ongoing wireless transmission of data to and from the vehicle computer 1, the vehicle computer 1 changes to the Shutdown mode.

The ignition is always off in the Shutdown mode and if the ignition is turned on in that mode, the vehicle computer 1 changes to the On mode. If the push button 14 is pushed for a longer time than the first predetermined time during the Shutdown mode, the vehicle computer has stayed in the Shutdown mode for a longer time than a fourth predetermined time or the first printed circuit board 3 during the Shutdown mode receives a signal from the motherboard 2 that the motherboard is ready for shutdown, the vehicle computer changes to the Standby mode.

If the ignition is turned on or if the push button 14 is pushed for a shorter time than the first predetermined time during the Standby mode, the vehicle computer 1 changes to the Pre-on mode. The ignition may be on or off during the Standby mode and since only the second printed circuit board 4 is fully powered (or in an internal standby mode) in the Standby mode, this mode can be maintained for a much longer time than the On mode and Black panel mode before having to shut down the vehicle computer 1 completely even when the ignition is off in the Standby mode. The vehicle computer 1 changes to the Off mode from the Standby mode with the ignition being off if the vehicle computer 1 continuously has been in the Standby mode longer than a fifth predetermined time, which is longer than the other predetermined times, or if the push button 14 is pushed for a longer time than the first predetermined time. An incoming call does not power up the motherboard 2 in the Standby mode.

## Claims

1. A vehicle computer (1), comprising a motherboard (2), a first printed circuit board (3) connected to the motherboard (2) for controlling power supply to at least the motherboard (2), **characterised by** a second printed circuit board (4) adapted for wireless telecommunications, the second printed circuit board (4) being connected to the first printed circuit board (3), and the first printed circuit board (3) comprises power control means (25, 37) adapted to cause the vehicle computer (1) to enter a first power mode (46) in which the power supply to the motherboard (2) is off and the power supply to the second printed circuit board (4) is on.

2. A vehicle computer (1) according to claim 1, being adapted for connection with a display means (8) and wherein the power control means (25, 37) also are adapted to cause the vehicle computer (1) to enter a second power mode (47) in which the power supply to the display means (8) is off whereas the power supply to the motherboard (2) and the second printed circuit board (4) is on.

3. A vehicle computer (1) according to claim 2, wherein the power control means (25, 37) also are adapted to cause the vehicle computer (1) to enter a third power mode (48) in which the second printed circuit board (4) is fully powered and the motherboard (2) is starting an operating system for the vehicle computer (1).

4. A vehicle computer (1) according to claim 3, wherein the power control means (25, 37) also are adapted to control power supply to a GPS signal receiver (13) connected to the first printed circuit board (3) in such a way that the power supply to the GPS signal receiver is off in the first power mode (46) and is on in the second power mode (47).

5. A vehicle computer (1) according to claim 3, wherein the power control means (25, 3 7) also enable the vehicle computer (1) to enter a fourth power mode (49) in which the second printed circuit board (4), the display means (8) and the motherboard (2) are fully powered or a fifth power mode (50) in which the power supply to the second printed circuit board (4), the display means (8) and the motherboard (2) is off.

6. A vehicle computer (1) according to any one of the preceding claims, comprising a video processor board (5) connected to the motherboard (2) and to a rear-view camera.

7. A vehicle_computer (1) according to any one of the preceding claims, wherein the second printed circuit board (4) is adapted for enabling GSM phone calls and SMS messages between the vehicle computer and a vehicle external device.

8. A vehicle comprising a vehicle computer (1) according to claim 1.

9. A printed circuit board (3) for a vehicle computer (1), comprising connector means adapted for communication with a motherboard (2) of the vehicle computer (1) and power control means (25, 37) for controlling supply of power to at least the motherboard (2) and a second printed circuit board (4) for wireless telecommunications with a vehicle external device, and **characterised by** a first connector (29) adapted for communication with the second printed circuit board (4), and that the power control means (25, 37) are adapted to cause the vehicle computer (1) to enter a first power mode (46) where the power supply to the motherboard (2) is off and the power supply to the second printed circuit board (4) is on.

10. A printed circuit board (3) according to claim 9, wherein the connector means adapted for communication with the motherboard (2) comprises a second connector (26) for receiving and transmitting signals related to power mode control and a third connector (30) adapted for receiving and transmitting information related to wireless telecommunications.

11. A printed circuit board (3) according to claim 9 or 10, comprising a CAN interface (27) for communication with at least one electronic control unit integrated in the vehicle.

12. A printed circuit board (3) according to claim 11, comprising a vehicle data logging means (39) for saving vehicle data received from the CAN interface (27) when vehicle data is received after an ignition signal has been received.

13. A computer program (37) for causing a first printed circuit board (3) in a vehicle computer (1) to control different power modes for the vehicle computer (1), where the vehicle computer (1) also comprises a motherboard (2) connected to the first printed circuit board (3) and a second printed circuit board (4) for wireless telecommunication connected to the first printed circuit board (3), **characterised by** computer usable code means which when run on the first printed circuit board (3) causes the vehicle computer (1) to enter a first power mode (46) in which power supply to the motherboard (2) is off and the power supply to the second printed circuit board (4) is on.

14. A computer program (37) according to claim 13, comprising computer usable code mean which when run on the first printed circuit board (3) causes the vehicle computer (1) to enter a second power mode (47) in which the power supply to the motherboard (2) and the second printed circuit board (4) is on whereas power supply to a display means (8) connected to the motherboard (2) is off.

15. A computer program (37) according to claim 14, comprising computer usable code means which when run on the first printed circuit board (3) causes the vehicle computer (1) to enter a third power mode (48) in which the second printed circuit board (4) is fully powered and the motherboard (2) is starting an operating system for the vehicle computer (1).

16. A computer program (37) according to claim 14 or 15, comprising computer usable code means which when run on the first printed circuit board (3) causes the power supply to a GPS signal receiver (13) connected to the first printed circuit board (3) to be off in the first power mode (46) and to be on in the second power mode (47).

17. A computer program product (36), comprising a computer readable medium and a computer program (37) according to claim 13 recorded on the computer readable medium.
